# EUROPÄISCHE PATENTANMELDUNG

(11) **EP 2 426 723 A2**
(43) Veröffentlichungstag der Anmeldung: **07.03.2012**
(21) Anmeldenummer: 11179417.8
(22) Anmeldetag: 30.08.2011
(51) Int. Cl.: H01L 31/0236, H01L 31/0224, H01L 31/068, H01L 31/18

(54) **Verfahren zur Herstellung einer Solarzelle**

(30) Priorität: 02.09.2010 DE 102010044271
(71) Anmelder: International Solar Energy Research Center Konstanz E.V., 78467 Konstanz (DE); Robert Bosch GmbH, 70442 Stuttgart (DE)
(72) Erfinder: Wefringhaus, Eckard, 88709 Meersburg (DE); Ferrada, Pablo, 78467 Konstanz (DE); Lossen, Jan, 99086 Erfurt (DE); Weiß, Mathias, 07743 Jena (DE)
(74) Vertreter: Patentanwälte Westphal, Mussgnug & Partner

(57) **Zusammenfassung**

Die Erfindung betrifft ein Verfahren zur Herstellung einer Solarzelle mit den Schritten Bereitstellen eines p- oder n-dotierten Halbleitersubstrats (201), das mindestens eine Oberfläche mit einer Textur mit Minima (203) und Maxima (202) aufweist, Eindiffundieren von n-Dotierungsatomen bei Verwendung eines p-dotierten Halbleitersubstrats (201) oder von p-Dotierungsatomen bei Verwendung eines n-dotierten Halbleitersubstrats (201) in die texturierte Oberfläche des p- oder n-dotierten Halbleitersubstrats (201) zur Erzeugung von diffundierten Wafern mit einem Emitter und Kontaktieren der Rückseite und der Oberseite des p- oder n-dotierten Halbleitersubstrats (201), wobei nach dem Bereitstellen des eines p- oder n-dotierten Halbleitersubstrats (201), das mindestens eine Oberfläche mit einer Textur mit Minima (203) und Maxima (202) aufweist, aber vor Beendigung des Eindiffundierens der Dotierungsatome ein Material zumindest auf Teile der Oberfläche des p- oder n-dotierten Halbleitersubstrats (201) aufgebracht wird, dessen Materialeigenschaften entweder so gewählt sind, dass das Material sich an den Minima (203) der Textur stärker anlagert als an den Maxima (202) der Textur oder so gewählt ist, dass das Material sich an den Maxima (202) der Textur stärker anlagert als an den Minima (203) der Textur.

## Beschreibung

Die Erfindung betrifft ein Verfahren zur Herstellung einer Solarzelle.

Solarzellen dienen der Stromerzeugung unter Ausnutzung von Licht, also von elektromagnetischer Strahlung, deren Wellenlänge insbesondere, aber nicht zwingend, im sichtbaren Spektralbereich liegt. Mit der Verwendung des Wortes "Licht" in diesem Dokument geht keine Beschränkung auf den sichtbaren Spektralbereich einher.

Der physikalische Effekt, auf dem diese Art der Stromerzeugung beruht, ist der innere Photoeffekt, genauer der photovoltaische Effekt. Beim inneren Photoeffekt, der bei Halbleitern auftritt, werden durch Wechselwirkung mit dem eingestrahlten Licht Elektronen aus dem Valenzband ins Leitungsband gehoben, also Elektron-Loch-Paare erzeugt, die die Leitfähigkeit des Halbleiters erhöhen.

Um eine derartige Ladungstrennung effizient zur Stromerzeugung nutzen zu können, ist es notwendig, eine Rekombination zu verhindern und die Ladungsträger gerichtet abzuführen. Dies kann durch Bereitstellung eines über den Erzeugungsbereich der Ladungsträger abfallenden elektrischen Felds erreicht werden. Eine einfache Möglichkeit, ein geeignetes elektrisches Feld im Halbleiter zu erzeugen liegt darin, durch geeignete Dotierung des Halbleiters einen Übergang zwischen einer p-Dotierung und einer n-Dotierung zu schaffen.

An einem p-n-Übergang kommt es zur Ausbildung von Raumladungen, da die jeweiligen Majoritätsladungsträger in den jeweils anders dotierten Bereich diffundieren und ein entsprechendes elektrisches Feld hervorrufen, durch das im Übergangsbereich erzeugte Ladungsträger in die entsprechende Richtung abgesaugt werden. Der Bereich mit dem elektrischen Feld wird als Raumladungszone bezeichnet.

Eine Solarzelle hat typischerweise folgenden Aufbau: Die Seite, welche dem Licht zugewandt ist, wird im Folgenden als "Oberseite" bezeichnet. Ein typischerweise mit einem Dotierungsgrad von 10¹⁵ cm⁻³ bis 10¹⁶ cm⁻³, p- oder n-dotiertes Substrat wird oberflächennah n- oder p-dotiert.

Die oberflächennahe, entgegengesetzt zum Substrat dotierte Schicht wird üblicherweise als Emitter bezeichnet, das dotierte Substrat als Basis. In dieser Patentschrift werden stark dotierte Bereiche des Emitters und schwach dotierte Bereiche des Emitters betrachtet. Für die stark dotierten Bereiche (des Emitters) wird auch die Bezeichnung n++ bzw. p++ verwendet, eine starke Dotierung (des Emitters) liegt bei Dotierungsgraden > ungefähr 10²⁰ cm⁻³ vor. Für die schwach dotierten Bereiche (des Emitters) wird auch die Bezeichnung n+ bzw. p+ verwendet, eine schwache Dotierung (des Emitters) liegt bei Dotierungsgraden zwischen ca. 10¹⁸ cm⁻³ und 10²⁰ cm⁻³ vor.

Um die Rekombination an der Rückseite zu minimieren wird dort meist eine starke Dotierung, das Back Surface Field, angebracht - stark p-dotiert für eine p-Basis oder stark n-dotiert für eine n-Basis. Dies spiegelt Ladungsträger in Richtung Raumladungszone und Emitter.

Einfallendes Licht, welches zur Stromerzeugung genutzt wird, wird in der Basis, dem Back Surface Field, dem Emitter oder in der Raumladungszone - unter Erzeugung eines Elektronen-Loch-Paares - absorbiert. Die zur Stromerzeugung benötigten Minoritätsladungsträger werden in der Raumladungszone durch das elektrische Feld zu den richtigen Kontakten hin gezogen. In den übrigen Bereichen des Substrats diffundieren die Ladungsträger und können so - wenn sie nicht rekombinieren - die Raumladungszone erreichen.

Im stark dotierten Emitter rekombinieren die Minoritätsladungsträger leicht, daher möchte man den Emitter möglichst dünn und niedrig dotiert gestalten.

Um die Solarzelle bestimmungsgemäß zur Stromerzeugung nutzen zu können ist es weiter notwendig, Basis und Emitter zu kontaktieren. Dies geschieht an der Unterseite z.B. mit einem Flächenkontakt. An der Oberseite ist dies nicht wünschenswert, da dadurch der Lichteinfall abgeschirmt würde. Daher ist auf der Oberseite der Solarzelle in der Regel lediglich ein finger- oder gitterartiger Kontakt vorgesehen, der insbesondere durch Siebdruck von Metall-Pasten erreicht werden kann.

Ein typischer Hauptbestandteil von Pasten für die Kontaktierung von p-dotierten Oberflächen ist Aluminium, für die Kontaktierung von n-dotierten Oberflächen Silber.

Insbesondere für finger- und gitterartige Kontakte ergibt sich dabei das Problem, dass ein niedriger Kontaktwiderstand umso einfacher zu erzielen ist, je niedriger der Schichtwiderstand des zu kontaktierenden Emitters ist. Der Schichtwiderstand wird üblicherweise in der Einheit **Ω**/sq angegeben und typischerweise durch eine Vierpunktmessung bestimmt. Emitter mit geringem Schichtwiderstand weisen aber eine hohe Oberflächen-Rekombinationsrate auf, was sich nachteilig auf die Effizienz einer Solarzelle auswirkt.

Aus dem Stand der Technik sind bislang drei Ansätze bekannt, um dieses Problem zu umgehen. Bei industrieller Massenproduktion wird der Schichtwiderstand des zu kontaktierenden Emitters auf einen Wert beschränkt, der noch eine Kontaktierung ermöglicht. Typische erreichte Werte liegen hier in Abhängigkeit von der für die Kontaktierung verwendeten Metallpaste zwischen 50**Ω**/sq und 80 **Ω**/sq. Dabei wird wegen der mit solchen Schichtwiderständen verbundenen signifikanten Oberflächenrekombination eine klare Verschlechterung des Wirkungsgrades in Kauf genommen, der Emitter stellt einen Kompromiss zwischen guter Kontaktierbarkeit mit Metall-Pasten und geringer Oberflächen-Rekombination dar.

Ebenfalls ist es bekannt, Solarzellen mit selektivem Emitter herzustellen. Dabei wird der Bereich unter den Kontaktfingern durch entsprechende Kontrolle des Diffusionsprozesses gezielt als niederohmiger, gut kontaktierbarer Emitter gestaltet, während im Bereich zwischen den Kontaktfingern ein hochohmiger Emitter erzeugt wird. Diese Vorgehensweise führt zu einem besseren Wirkungsgrad, ist jedoch teuer, da eine größere Anzahl von Prozessschritten nötig ist.

Eine weitere Vorgehensweise, die aus der DE 195 22 539 A1 bekannt ist, besteht darin, eine stark n-dotierte Schicht auf das Halbleitersubstrat aufzubringen und dann mit Hilfe von Masken selektiv so zu ätzen, dass eine Vielzahl sich gegenseitig kreuzender, nach oben spitz zulaufender Rippenzüge erzeugt wird, deren oberer Abschnitt aus einer stark n-dotierten Schicht und deren unterer Abschnitt aus dem Basismaterial besteht. In einem weiteren Dotierungsschritt erfolgt dann eine schwache Dotierung der freiliegenden Bereiche des Basismaterials. Da aber ein Photolithographie-Schritt benötigt wird, ist diese Vorgehensweise zu teuer für industrielle Anwendung.

Die Aufgabe der Erfindung besteht darin, ein kostengünstiges und prozesstechnisch einfach durchzuführendes Verfahren zur Herstellung einer Solarzelle, die einen hochohmigen, aber dennoch gut kontaktierbaren Emitter aufweist, bereitzustellen.

Diese Aufgabe wird gelöst durch ein Verfahren zur Herstellung einer Solarzelle mit den Merkmalen des Patentanspruchs 1. Vorteilhafte Ausgestaltungen und Weiterbildungen der Erfindung sind in den Unteransprüchen angegeben.

Das erfindungsgemäße Verfahren zur Herstellung einer Solarzelle weist den Schritt des Bereitstellens eines p- oder n-dotierten Halbleitersubstrats, das mindestens eine Oberfläche mit einer Textur mit Minima und Maxima, also eine texturierte Oberfläche aufweist, auf. Die texturierte Oberfläche kann beispielsweise bei monokristallinen Solarzellen durch Ätzung eines Silizium-Substrats in einem alkalischen Medium erzeugt werden, was zu einer Textur aus zufällig angeordneten Pyramiden führt, deren Seitenflächen den <111>-Richtungen des Siliziumkristalls entsprechen; bei multikristallinen SiliziumSubstraten kann eine Textur in Form von Ätzgrübchen durch Ätzung in saurem Medium hergestellt werden.

Als weiterer Verfahrensschritt erfolgt das Eindiffundieren von n-Dotierungsatomen bei Verwendung eines p-dotierten Halbleitersubstrats oder von p-Dotierungsatomen bei Verwendung eines n-dotierten Halbleitersubstrats in die texturierte Oberfläche des p- oder n-dotierten Halbleitersubstrats zur Erzeugung von diffundierten Wafern mit einem Emitter und das Kontaktieren der Rückseite und der Oberseite des p- oder n-dotierten Halbleitersubstrats. Weitere Hochtemperaturschritte, wie z.B. PECVD-Prozesse oder Sintern, die grundsätzlich das erzielte Diffusionsprofil noch beeinflussen können, gelten nicht als Teil des Diffusionsschrittes gemäß dieser Patentschrift.

Die vorstehend beschriebenen Schritte werden zweckmäßigerweise in dieser Reihenfolge, aber nicht zwingend unmittelbar nacheinander durchgeführt werden.

Erfindungswesentlich ist, dass vor Beendigung des Eindiffundierens der Dotierungsatome ein Material zumindest auf Teile der texturierten Oberfläche des p- oder n-dotierten Halbleitersubstrats aufgebracht wird, dessen Materialeigenschaften entweder so gewählt sind, dass das Material sich an den Minima der Textur stärker anlagert als an den Maxima der Textur oder so gewählt ist, dass das Material sich an den Maxima der Textur stärker anlagert als an den Minima.

Der Erfindung liegt der Gedanke zu Grunde, dass eine im Regelfall ohnehin vorliegende texturierte Oberfläche des Halbleitersubstrats eine Oberflächenstruktur bereitstellt, die in Verbindung mit einem Material mit geeigneten Materialeigenschaften zu einer selbstjustierenden Verteilung des Materials auf der texturierten Oberfläche führt und damit eine Strukturierung ohne zusätzlichen Strukturierungsschritt ermöglicht. Dies bringt insbesondere den Vorteil mit sich, dass sich eine relative Ausrichtung von Strukturen gegeneinander erübrigt und durch Fehlausrichtung bedingter Ausschuss im Fertigungsprozess vermieden wird. Das angelagerte Material kann je nach Wahl der Flüssigkeit einerseits als Diffusionsbarriere und andererseits als Diffusionsquelle wirken.

Eine verstärkte Anlagerung an den Minima der Textur kann beispielsweise dadurch erreicht werden, dass eine Flüssigkeit mit so geringer Viskosität und so geringer Oberflächenspannung auf die texturierte Oberfläche aufgetragen wird, dass sie sich unter Einwirkung der Schwerkraft in den lokalen Minima der Textur sammelt, während die Oberfläche der texturierten Oberfläche an den Maxima der Textur allenfalls mit einer dünnen Schicht der Flüssigkeit bedeckt bleibt.

Alternativ kann z.B. ein rieselfähiger Feststoff eingesetzt werden, z.B. feine TiO-Partikel, die auf die texturierte Oberfläche aufgestreut werden und durch Rütteln in die Minima der Textur wandern.

Eine verstärkte Anlagerung an den Maxima der Textur wird beispielsweise dadurch erreicht, dass nur die Maxima der Textur in Kontakt mit einer so hochviskosen und eine so hohe Oberflächenspannung aufweisenden Flüssigkeit gebracht werden, dass diese sich nicht unter Einwirkung der Schwerkraft weiter verteilt, z.B. durch kontrolliertes Eintauchen der Maxima in einen Flüssigkeitsspiegel dieser Flüssigkeit.

Mit einem Feststoff kann eine derartige Anlagerung erreicht werden, wenn nur die Maxima der Textur in Kontakt mit einem am Halbleitersubstrat haftfähige Pulver gebracht wird, z.B. durch kontrolliertes Eintauchen der Maxima der Textur in ein solches Pulver.

In einer bevorzugten Ausführungsform des Verfahrens wird eine Flüssigkeit aufgebracht und dann verfestigt oder ausgehärtet, beispielsweise durch eine Trocknungs- oder Tempervorgang. Dadurch wird die im flüssigen Zustand eingestellte Verteilung der Flüssigkeit auf den Maxima und Minima der texturierten Oberfläche des Substrats fixiert.

Im Bereich der Maxima oder an den Maxima der Textur oder im Bereich der Minima oder an den Minima der Textur verstärkt angelagerte Flüssigkeit kann je nach Wahl der Flüssigkeit als eine Diffusionsbarriere oder als eine Diffusionsquelle verwendet werden. Um eine Diffusionsbarriere zu erzeugen eignen sich insbesondere Polysilazane, Solgele oder in einer Trägerflüssigkeit dispergierte TiO-Partikel. Eine Diffusionsquelle erhält man insbesondere bei Verwendung von Phosphorsäure, dotierten Polysilizanen, dotierten Solgelen, in einer Trägerflüssigkeit dispergierten dotierten Siliziumpartikeln oder in einer Trägerflüssigkeit dispergierten Phosphoroxidpartikeln.

Da bei einem niedrigen Kontaktwiderstand zur Vorderseitenmetallisierung nur wenig Kontaktfläche nötig ist, können die Flächenanteile mit starker und schwacher Dotierung so gewählt werden, dass der niedrig dotierte Bereich den größeren Flächenanteil der Oberfläche ausmacht. Idealerweise sollte die Vorderseitenmetallisierung so aufgebracht werden oder so formuliert sein, dass die Kontaktbildung in den stark dotierten Bereichen besonders begünstigt wird.

In einer besonders bevorzugten Ausführungsform des Verfahrens erfolgt an den Minima der texturierten Oberfläche des Halbleitersubstrats beim Eindiffundieren der Dotierungsatome eine stärkere Dotierung als an den Maxima der texturierten Oberfläche und zur Kontaktierung der Oberseite wird eine Tinte verwendet, in der Nanopartikel aus Silber und Glasfritte in einer so niedrigviskosen Trägerflüssigkeit dispergiert sind, so dass die Nanopartikel aus Silber sich nach der Aufbringung hauptsächlich an den Minima der texturierten Oberfläche sammeln.

Es kann zweckmäßig sein, die Flüssigkeit nach Abschluss des Diffusionsprozesses vom Halbleitersubstrat zu entfernen. Dies kann gemeinsam mit der Entfernung von Rückständen des Diffusionsprozesses, z.B. entstandenem Phosphorglas, erfolgen.

Die Erfindung wird anhand der nachfolgenden Figuren weiter erläutert. Es zeigt:
- Figur 1: ein Blockdiagramm einer Ausführungsform des erfindungsgemäßen Verfahrens,
- Figur 2a: eine schematische Darstellung des nach Schritt 103 gemäß Figur 1 vorliegenden Halbleitersubstrats,
- Figur 2b: eine schematische Darstellung des nach Schritt 104 gemäß Figur 1 vorliegenden Halbleitersubstrats, und
- Figur 2c: eine schematische Darstellung des nach Schritt 105 der Figur 1 vorliegenden Halbleitersubstrats.

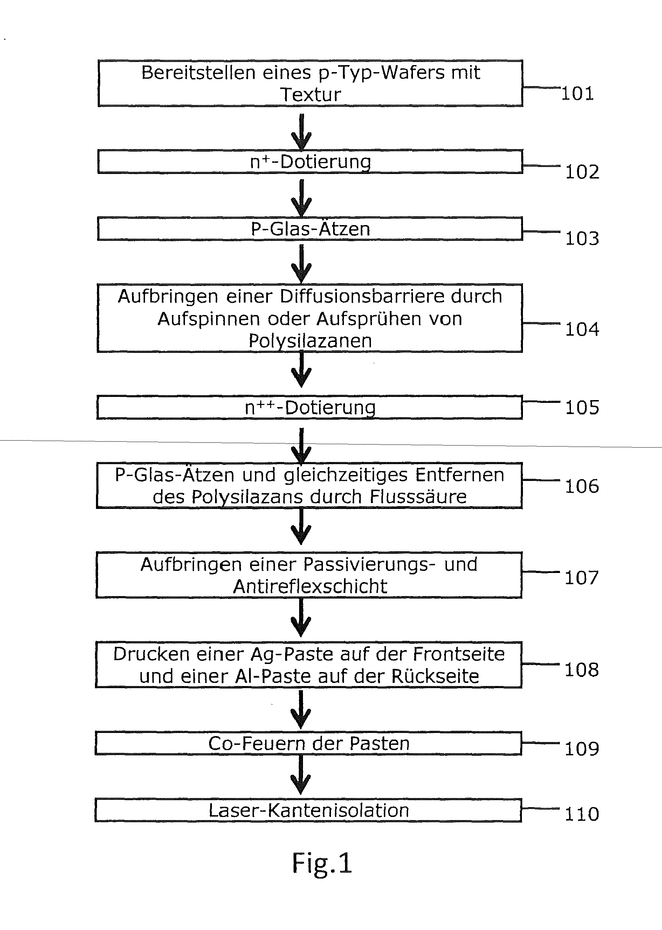

Figur 1 zeigt eine konkrete Ausführungsform des Verfahrens. Im Schritt 101 wird ein p- oder n-dotiertes Halbleitersubstrat, das mindestens eine Oberfläche mit einer Textur mit Minima und Maxima aufweist, bereitgestellt. Die Texturierung kann z.B. bei Verwendung eines monokristallin gewachsenen Siliziumsubstrats durch alkalisches Ätzen eines [100] Schnitts mit NaOH oder KOH, ggf. gemischt mit Isopropanol, erfolgen und führt zur Ausbildung von Pyramiden, da [100]-Ebenen schneller als [111] Ebenen des Silizium weggeätzt werden. Dabei werden zugleich etwaige Schäden, die beim Sägen der Wafer entstanden sein könnten, entfernt. Im Fall der Verwendung eines multikristallinen Substrats ist eine Texturierung durch Ätzen mit einer Lösung von HF, HN0₃ und Wasser möglich. Entsprechende Verfahren für die Behandlung von n-Typ-Wafern sind bekannt.

Im Schritt 102 erfolgt eine schwache n-Dotierung des p-Typ-Wafers auf bekannte Art und Weise, beispielsweise durch Aufbringen von POC13 aus der Gasphase und Eindiffundieren von Phosphoratomen. Grundsätzlich ist dieser Schritt nicht zwingend erforderlich. Analoge Prozesse zur p-Dotierung eines n-Typ-Wafers sind ebenfalls literaturbekannt.

Bei den Dotierprozessen wie sie im Schritt 102 vorgesehen sind können Rückstände auf der Oberfläche des Halbleitersubstrats zurückbleiben, die im Schritt 103 durch Ätzen entfernt werden, was z.B. mit 3%iger Flusssäure bei Raumtemperatur durchgeführt werden kann.

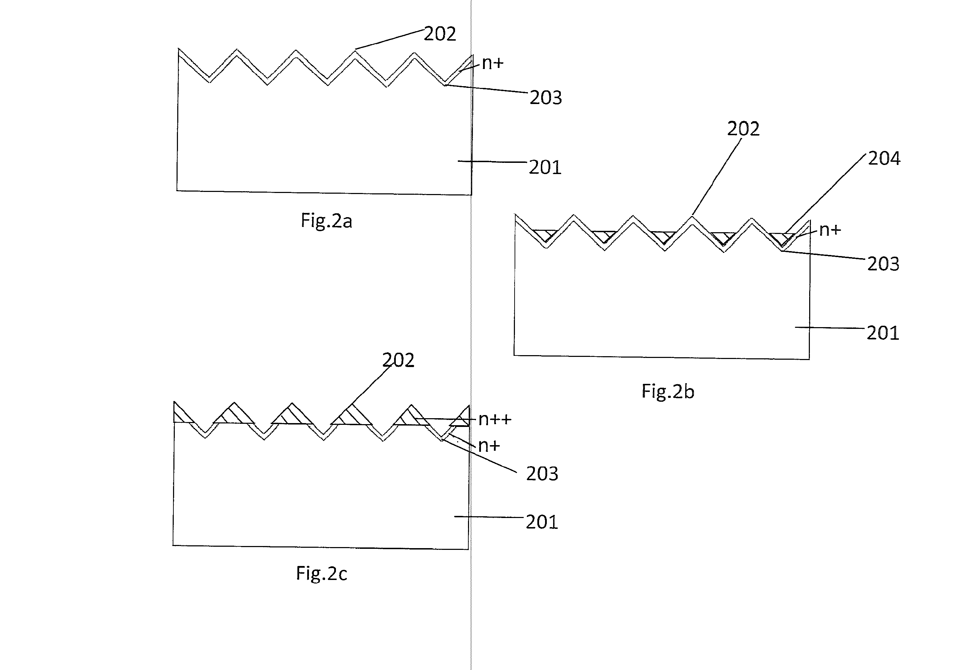

Nach den Schritten 101 bis 103 erhält man somit ein Halbleitersubstrat mit einem in Figur 2a schematisch dargestellten Aufbau. Man erkennt ein Halbleitersubstrat 201 vom p-Typ, das eine Textur mit lokalen Maxima 202 und lokalen Minima 203 aufweist. Die Textur ist regelmäßig dargestellt, in der Praxis kann sie aber auch unregelmäßiger sein. Durch den Diffusionsschritt 102 ist eine gleichmäßige Diffusionszone n+ mit schwacher Dotierung im oberflächennahen Bereich des Halbleitersubstrats 201 entstanden.

Wieder im Bezug auf Figur 1 erfolgt als nächstes im Schritt 104 das erfindungsgemäße Aufbringen einer Flüssigkeit, die hier mit geringer Viskosität und Oberflächenspannung ausgebildet ist. Beispielsweise kann Polysilazen durch Aufspinnen oder Aufsprühen aufgebracht werden. Wegen der geringen Viskosität und Oberflächenspannung sammelt sich, wie in Figur 2b zu erkennen ist, die aufgesprühte Flüssigkeit 204 in den Minima 203 der Textur.

Figur 1 zeigt als nächsten Schritt 105 das Vornehmen einer weiteren n-Dotierung, die in ähnlicher Weise wie Schritt 102 ausgeführt werden kann. Dabei wirkt das Polysilazen als Diffusionsbarriere, so dass, wie in Figur 2c schematisch dargestellt ist, eine starke n-Dotierung n++ an den Maxima 202 der Textur erfolgt, an denen kein Polysilazen angelagert wurde, während im Bereich der Minima des Halbleitersubstrats weiterhin ein schwach dotierter Bereich n+ vorliegt. Falls Schritt 102 nicht ausgeführt wurde, ist es ebenfalls möglich, die Parameter des Diffusionsprozesses so zu wählen, dass in den Bereichen, in denen die Diffusionsbarriere angelagert wurde, ein schwach dortierter Bereich n+ entsteht.

Im Schritt 106 nach Figur 1 wird ein weiterer optionaler Ätzschritt vorgenommen, mit dem Rückstände, die beim Prozess der starken Dotierung auf der Oberfläche entstanden sein können entfernt werden können. Mit diesem Ätzschritt ist es auch möglich, die in den Minima 203 angelagerte Flüssigkeit zu entfernen. Es können dieselben Verfahren, die oben zu Schritt 103 beschrieben wurden, zum Einsatz kommen.

Im Schritt 107 wird der Emitter optional mit einer Passivierungs- und Antireflexschicht versehen. Diese kann beispielsweise aus Siliziumnitrid bestehen und mittels SiNₓ -Sputtering, LPCVD (low pressure chemical vapour deposition) oder PECVD (plasma enhanced chemical vapour deposition) aufgebracht werden, wobei die letztgenannte Schicht besonders geeignet ist.

Im Schritt 108 erfolgt dann die Kontaktierung von Basis und Emitter, z. B. durch Siebdruck einer gitterartigen Struktur mit silberhaltiger Paste auf die Vorderseite, weitgehend ganzflächigem Siebdruck mit aluminiumhaltiger Paste auf die Hinterseite und Siebdruck mit aluminium-silberhaltiger Paste von Strukturen zum Verlöten der Solarzellen auf die Hinterseite. Anschließend erfolgt im Schritt 109 das Einsintern der Pasten, z.B. in einem Infrarot-Gürtelofen.

Schließlich wird als Schritt 110 optional eine Laser-Kantenisolation vorgenommen.

### Bezugszeichenliste

- 101-110: Verfahrensschritte
- 201: Halbleitersubstrat
- 202: Maximum
- 203: Minimum
- 204: Flüssigkeit
- n+: schwach dotierter Bereich
- n++: stark dotierter Bereich

## Patentansprüche

1. Verfahren zur Herstellung einer Solarzelle mit den Schritten
- Bereitstellen eines p- oder n-dotierten Halbleitersubstrats (201), das mindestens eine Oberfläche mit einer Textur mit Minima (203) und Maxima (202) aufweist
- Eindiffundieren von n-Dotierungsatomen bei Verwendung eines p-dotierten Halbleitersubstrats (201) oder von p-Dotierungsatomen bei Verwendung eines n-dotierten Halbleitersubstrats (201) in die texturierte Oberfläche des p- oder n-dotierten Halbleitersubstrats (201) zur Erzeugung von diffundierten Wafern mit einem Emitter und
- Kontaktieren der Rückseite und der Oberseite des p- oder n-dotierten Halbleitersubstrats (201),
**dadurch gekennzeichnet, dass**
nach dem Bereitstellen des p- oder n-dotierten Halbleitersubstrats (201), das mindestens eine Oberfläche mit einer Textur mit Minima (203) und Maxima (202) aufweist, aber vor Beendigung des Eindiffundierens der Dotierungsatome ein Material zumindest auf Teile der Oberfläche des p- oder n-dotierten Halbleitersubstrats (201) aufgebracht wird, dessen Materialeigenschaften entweder so gewählt sind, dass das Material sich an den Minima (203) der Textur stärker anlagert als an den Maxima (202) der Textur oder so gewählt ist, dass das Material sich an den Maxima (202) der Textur stärker anlagert als an den Minima (203) der Textur.

2. Verfahren nach Anspruch 1,
**dadurch gekennzeichnet, dass** das Material eine Flüssigkeit ist und die Materialeigenschaften die Viskosität und/oder die Oberflächenspannung sind.

3. Verfahren nach Anspruch 2,
**dadurch gekennzeichnet, dass** die Flüssigkeit nach dem Aufbringen verfestigt oder ausgehärtet wird.

4. Verfahren nach einem der Ansprüche 1 bis 3,
**dadurch gekennzeichnet, dass** das Material eine Quelle für Dotierungsatome ist.

5. Verfahren nach einem der Ansprüche 1 bis 3,
**dadurch gekennzeichnet, dass** das Material eine Diffusionsbarriere darstellt.

6. Verfahren nach einem vorstehenden Anspruch,
**dadurch gekennzeichnet, dass** an den Minima (203) der texturierten Oberfläche des Halbleitersubstrats (201) beim Eindiffundieren der Dotierungsatome eine stärkere Dotierung erfolgt als an den Maxima (202) der texturierten Oberfläche und dass zum Kontaktieren der Oberseite des Halbleitersubstrats (201) eine Tinte verwendet wird, in der Nanopartikel aus Silber und Glasfritte in einer so niedrigviskosen Trägerflüssigkeit dispergiert sind, dass die Nanopartikel aus Silber sich nach der Aufbringung hauptsächlich an den Minima (203) der texturierten Oberfläche sammeln.
